# EUROPEAN PATENT APPLICATION

(11) **EP 0 798 859 A2**
(43) Date of publication of application: **01.10.1997**
(21) Application number: 97105307.9
(22) Date of filing: 27.03.1997
(51) Int. Cl.: H03K 19/00

(54) **A circuit arrangement and method for extending the applicable voltage range and maintaining high input impedance of MESFET and HEMT circuits**

(30) Priority: 28.03.1996 GB 9606513
(71) Applicant: Bushehri, Ebrahim, London N11 2NQ (GB); Saber, Majid, London N11 2NQ (GB)
(72) Inventor: Bushehri, Ebrahim, London N11 2NQ (GB); Saber, Majid, London N11 2NQ (GB)
(74) Representative: Meddle, Alan Leonard

(57) **Abstract**

A circuit arrangement having an input terminal connected through a plurality of forward biased Schottky diodes (Jd1,Jd2..Jdn) connected in series to a gate of a transistor (Jd), wherein each Schottky diode (Jd1,Jd2..Jdn) has a Schottky barrier voltage and the number of Schottky diodes (Jd1,Jd2..Jdn) is selected such that the sum of the Schottky barrier voltages of the Schottky diodes (Jd1,Jd2..Jdn) connected in series plus the Schottky barrier voltage of the transistor gate-source diode is higher than a maximum voltage (Vₙₛ) between the input terminal (N) and the source terminal of the transistor (Jd) such that the impedance of the input terminal remains high.

## Description

THIS INVENTION relates to a circuit arrangement and method for extending the applicable voltage range and maintaining high input impedance of a terminal of circuits which utilize transistors, particularly metal field effect transistors, with the presence of a Schottky diode at the gate region. Examples of such transistors are GaAs MESFETs (Metal Semiconductor Field Effect Transistors) or GaAs/AlGaAs HEMTs (High Electron Mobility Transistors).

The present invention is applicable to circuits where the drain-source current of such a transistor has to be controlled by a voltage applied to a terminal. Specifically, the invention provides a solution for giving such a terminal high input impedance characteristics for any desired input voltage range by adding Schottky diodes in series between the terminal and the gate of the transistor. This solution can be applied for any type of circuits utilizing transistors with the presence of a Schottky diode at the gate region where a current flow is to be controlled by a voltage applied to a terminal without any considerable current drawn, hence the requirement for high impedance at the terminal over a voltage range exceeding that of the Schottky barrier potential.

Transistors with a Schottky diode present at the gate region have the disadvantage of a limited gate-source voltage range for which the input impedance remains high. Once the applied gate-source voltage approaches the Schottky barrier voltage of the gate diode, the gate-source current increases rapidly. The input impedance of the gate terminal becomes low and the gate current flow prevents any further substantial rise of the gate-source voltage, i.e. the gate diode clamps the input voltage.

For a number of applications such as Voltage Controlled Oscillators (VCOs) this brings about a number of practical problems when using transistors with a Schottky diode at the gate region. The operation of such circuits usually relies on the dependency of the delay of an inverter on the current available to charge and discharge its output node. In standard gates this current is fixed whereas in gates for VCOs and similar circuits, this current is controlled through a voltage applied to an additional control voltage terminal. This voltage controls the current flow through current supplying transistors and thereby the gate delay is made voltage dependent. In VCOs the control voltage terminal is usually connected directly to a filter and should have high input impedance in order not to deteriorate the filter characteristics. In addition, the control voltage range should be as large as possible, preferably in the same range as the supply voltage.

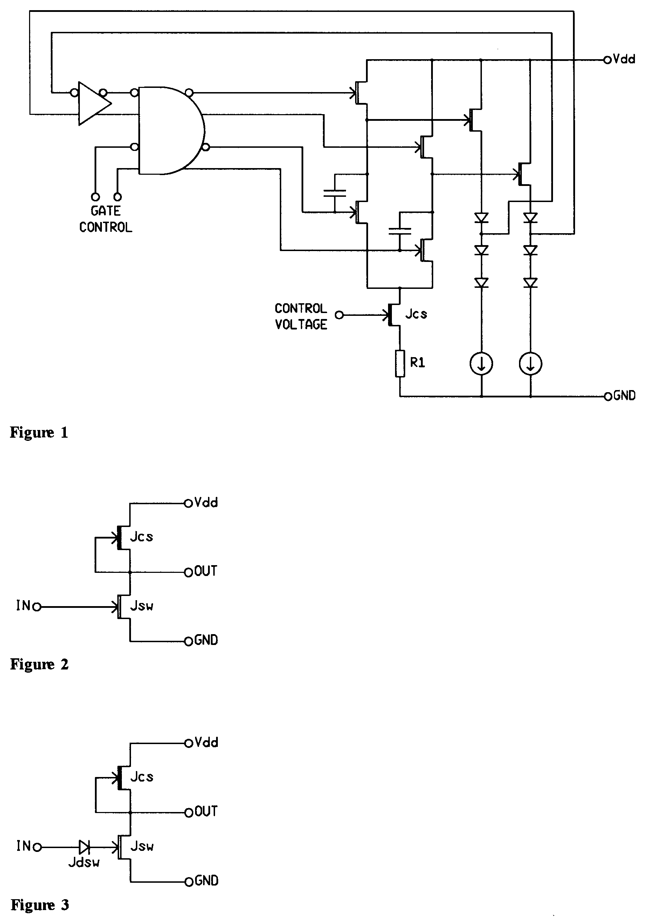

A VCO application using MESFETs is described in "A Wide Tuning Range Gated Voltage-Controlled Oscillator" by Tyler G. Bowman and Frederick G. Weiss, GaAs IC Symposium 1989 IEEE. A control voltage range beyond the Schottky barrier potential limit was achieved by using a resistor between the source terminal of the current controlling MESFET Jcs and the negative supply rail as shown in Figure 1 of the accompanying drawings. In this scheme the source voltage of the transistor rises with higher control voltages due to the higher current flow through resistor R1. As a result, the value of the control voltage with respect to the negative rail at which the gate-source diode of the transistor begins to draw a considerable current is higher than the Schottky barrier potential. Despite this improvement, the control voltage range of the VCO is much below the desirable full supply voltage range. For high control voltages the input impedance of the control voltage terminal becomes low and the diode clamps the voltage.

The clamping effect of the Schottky gate diode also limits the high signal level in digital circuits such as Direct Coupled FET Logic (DCFL) gates. A DCFL inverter is shown in Figure 2 of the accompanying drawings. In "A Simple Method To Improve the Noise Margin of III-V DCFL Digital Circuit Coupling Diode FET Logic" by Long Yang, Albert T. Yuen and Stephen I. Long, IEEE Electron Device Letters, Vol. EDL-7, NO. 3, March 1986, a simple approach is presented to increase the high signal level at the inverter input by adding a diode in series with the gate of the input transistor. This proposed scheme, called Coupling Diode FET Logic (CDFL), is shown in Figure 3 of the accompanying drawings. However, in this scheme the additional diode only increases the voltage level for which clamping occurs so as to obtain higher signal levels rather than to provide high input impedance. The same applies to similar circuits using diodes connected in series with the gate of a MESFET as described in U.S. Pat. No. 4,713,559. In these applications the diodes function as level shifters utilizing the nearly constant voltage drop provided by highly forward biased Schottky diodes and are used for current summing.

An object of the present invention is to provide circuits with a terminal for which the input voltage range can be increased to any desired value while maintaining high input impedance throughout this voltage range.

Accordingly, one aspect of the present invention provides a circuit arrangement having an input terminal connected through a plurality of forward biased Schottky diodes connected in series to a gate of a transistor, wherein each Schottky diode has a Schottky barrier voltage and the number of Schottky diodes is selected such that the sum of the Schottky barrier voltages of the Schottky diodes connected in series plus the Schottky barrier voltage of the transistor gate-source diode is higher than a maximum voltage between the input terminal and the source terminal of the transistor such that the impedance of the input terminal remains high.

In another aspect, the present invention provides a method of maintaining a high input impedance for a circuit arrangement having an input terminal connected through a plurality of forward biased Schottky diodes connected in series to a gate of a transistor, each Schottky diode having a Schottky barrier voltage, which method comprises the step of selecting the number of Schottky diodes connected in series to the gate region such that the sum of the Schottky barrier voltages of the Schottky diodes connected in series plus the Schottky barrier voltage of the transistor gate-source diode is higher than a maximum voltage between the input terminal and the source terminal of the transistor such that the impedance of the input terminal remains high.

In a further aspect, the present invention provides a method for extending the voltage range and maintaining high input impedance of a terminal in a circuit for controlling the current flow, delay, power dissipation and function of the circuit by connecting the terminal through a series of forward biased Schottky diodes to the gate of a transistor with the presence of a Schottky diode at the gate region to control its drain current, each Schottky diode having a Schottky barrier voltage, the high input impedance of the terminal being provided by applying Schottky diodes connected in series in such numbers that the sum of the Schottky barrier voltages of the diodes connected in series plus the Schottky barrier voltage of the transistor gate-source diode is higher than the maximum voltage applied between the terminal and the source terminal of the transistor.

Preferably, the diodes operate as a high impedance voltage divider such that a fraction of the terminal input voltage is effective as the gate-source voltage of the transistor, which fraction is dependent on the number of Schottky diodes connected in series.

Desirably, the operating range of the diode voltage divider is restricted to the region of its current versus voltage characteristics for which the parasitic diode series resistances have virtually no effect on the ideal exponential relationship between diode current and forward voltage.

The sum of the Schottky barrier voltages of the diodes connected in series plus the Schottky barrier voltage of the transistor gate-source diode is preferably considerably higher than the maximum voltage applied between the terminal and the source terminal of the transistor.

Advantageously, all the Schottky diodes have substantially the same parasitic capacitance.

Conveniently, all the Schottky diodes are of the same type and geometrical size as the transistor gate diode formed by the gate region of the transistor. The Schottky diodes may comprise transistors having their source and drain shorted.

In order that the present invention may be more readily understood, embodiments thereof will now be described, by way of example, with reference to the accompanying drawings, in which:
Figure 1 is a circuit diagram of a known gated VCO utilizing an inverter in which the delay is controlled by a voltage applied to the control voltage terminal;
Figure 2 shows a known direct coupled FET logic (DCFL) inverter;
Figure 3 shows a known coupling diode FET logic (CDFL) inverter;
Figure 4 shows the circuit arrangement used by the present invention to achieve the desired properties of a circuit terminal using Schottky diodes;
Figure 5 shows the circuit arrangement used by the present invention to achieve the desired properties of a circuit terminal using Schottky diodes made from transistors with their drain and source shorted;
Figure 6 is a graph showing the current (y-axis, from 0 to 1mA) versus voltage (x-axis, from 0 to 2.0V) characteristics of: a Schottky diode at the gate of a MESFET (curve I_SD1); the circuit arrangement of Figure 4 with one Schottky diode connected in series with the gate of a MESFET (curve I_SD2); and resistors with values of 100Ω (curve I_R100), 1kΩ (curve I_1K), 10kΩ (curve I_R10K) and 100kΩ (curve I_R100K);
Figure 7 is a graph showing the current (y-axis in logarithmic scale, from 1.0pA to 10.0mA) versus voltage (x-axis, from 0 to 2.0V) characteristics of: a Schottky diode at the gate of a MESFET (curve I_SD1); the circuit arrangement of Figure 4 with one Schottky diode connected in series with the gate of a MESFET (curve I_SD2); and resistors with values of 100Ω (curve I_R100), 1kΩ (curve I_1K), 10kΩ (curve I_R10K), 100kΩ (curve I_R100K) and 1MΩ (curve I_R1MEG);
Figure 8 is a graph showing the resistance (y-axis in logarithmic scale, from 10.0Ω to 10.0MΩ) versus voltage (x-axis, from 0 to 2.0V) characteristics of: a Schottky diode at the gate of a MESFET (curve I_SD1); the circuit configuration of Figure 4 with one Schottky diode connected in series with the gate of a MESFET (curve I_SD2); and resistors with values of 100Ω (curve I_R100), 1kΩ (curve I_1K), 10kΩ (curve I_R10K), 100kΩ (curve I_R100K) and 1MΩ (curve I_R1MEG);
Figure 9 shows the circuit of Figure 1 modified according to the present invention by replacing transistor Jcs and resistor R1 by a circuit arrangement according to Figure 4;
Figure 10 shows the DCFL inverter of Figure 2 modified to include a circuit arrangement according to Figure 4 thus adding a control voltage terminal and making the inverter current and hence delay voltage controllable;
Figure 11 is a circuit diagram of a known source coupled FET logic (SCFL) inverter;
Figure 12 shows the SCFL inverter of Figure 11 modified to include the circuit arrangement of Figure 4 thus adding a control voltage terminal and making the inverter current and hence delay voltage controllable;
Figure 13 shows the DCFL inverter with voltage controlled current and hence delay of Figure 10 extended to accommodate DCFL logic functions;
Figure 14 shows the SCFL inverter with voltage controlled current and hence delay of Figure 12 extended to accommodate SCFL logic functions;
Figure 15 shows a known inverter utilizing MOSFETs with voltage controlled delay by means of a variable capacitive load;
Figure 16 shows the inverter with voltage controlled delay of Figure 15 modified to include the circuit arrangement of Figure 4 thus making the circuit suitable for an implementation utilizing transistors with the presence of a Schottky diode at the gate region; and
Figure 17 shows a pass transistor structure which utilizes the circuit arrangement of Figure 4 to provide selection inputs with high input impedance, thus preventing current flow into the selection inputs.

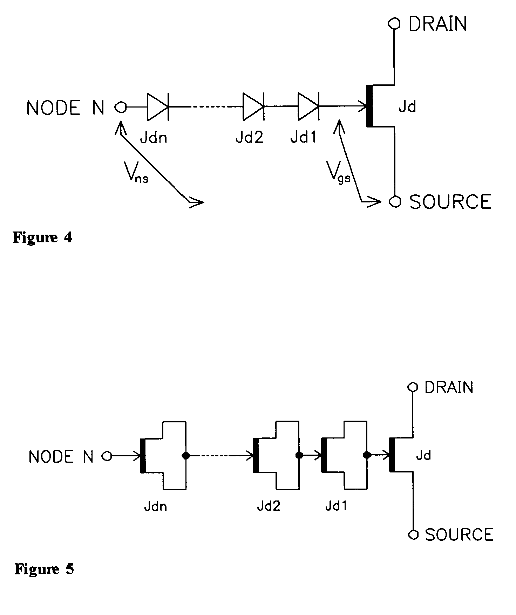

Referring to the circuit arrangement of Figure 4 which is used to describe the underlying principle of the invention, a number of forward biased Schottky diodes Jd1...Jdn (where n is the number of diodes) are connected in series to form a forward biased diode voltage divider between a terminal N and a gate of a transistor Jd, so that the Schottky diode at the gate of the transistor is part of this diode voltage divider. Provided all these diodes have equal characteristics, a voltage Vₙₛ applied between the terminal N and the source terminal of the transistor is therefore divided by n+1 and the (n+1)th part of this voltage becomes the effective gate-source voltage of transistor Jd.

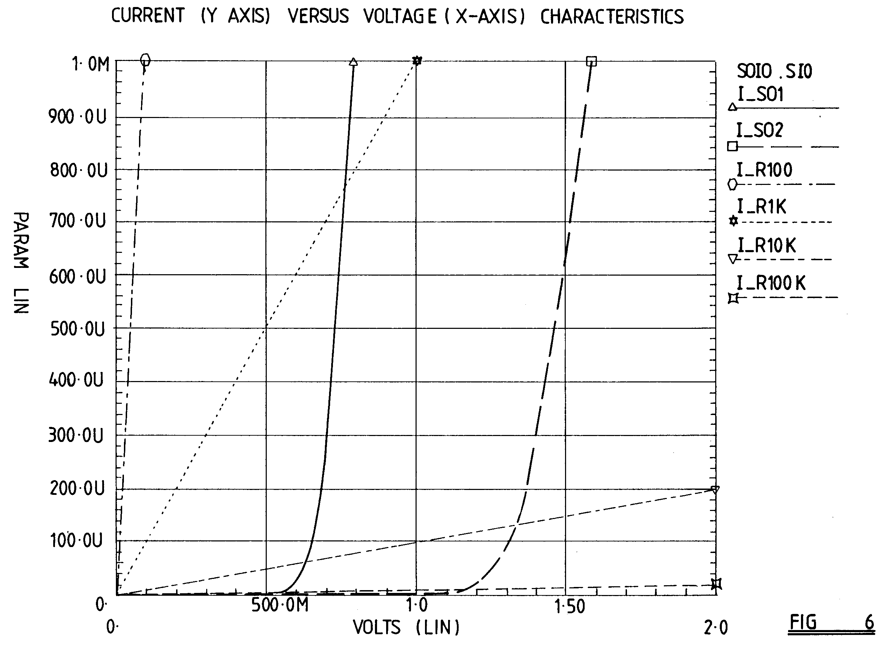

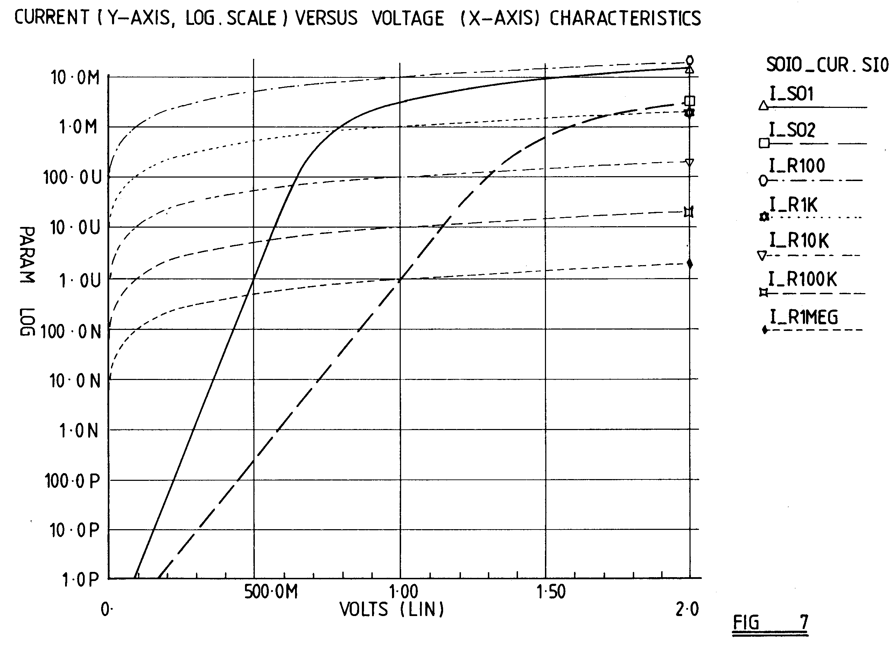

In known techniques, Schottky diodes are added for level shifting and summing currents, meaning that the operating range of the diodes includes voltages close to their Schottky barrier voltage where they draw large resistive currents. Figure 6 gives examples of current versus voltage characteristics for a single Schottky diode present at the gate of a MESFET (curve I_SD1) and a diode voltage divider with one diode in series with the diode present at the gate of a MESFET (curve I_SD2). The steep regions of the curves I_SD1 and I_SD2 show the operating range for which large resistive currents are drawn. Figure 7 shows the curves I_SD1 and I_SD2 of Figure 6 on a logarithmic scale for the current (y-axis). The nonlinear regions of the curves I_SD1 and I_SD2 in Figure 7 correspond to the steep regions of the curves I_SD1 and I_SD2 in Figure 6. The linear sections of the curves in Figure 7 represent the regions of the current versus voltage characteristics for which the parasitic diode series resistances have virtually no effect on the ideal exponential relationship between diode current and forward voltage.

In known techniques the number of diodes is such that the operating range of the diode voltage divider includes the nonlinear region of its characteristics according to Figure 7, where the diodes draw resistive current. In contrast to previous art, this invention prevents resistive current flow through the diodes thus avoiding operation of the diode voltage divider in the nonlinear region of its characteristics. This is achieved by employing diodes in series, according to Figure 4, in such numbers that for the maximum possible voltage applied, the operating range of the diode voltage divider is restricted to the linear region of its current versus voltage characteristics according to Figure 7, i.e the sum of the Schottky barrier voltages of the Schottky diodes connected in series plus the Schottky barrier voltage of the transistor gate-source diode is considerably higher than a maximum voltage between the input terminal and the source terminal of the transistor such that the impedance of the input remains high.

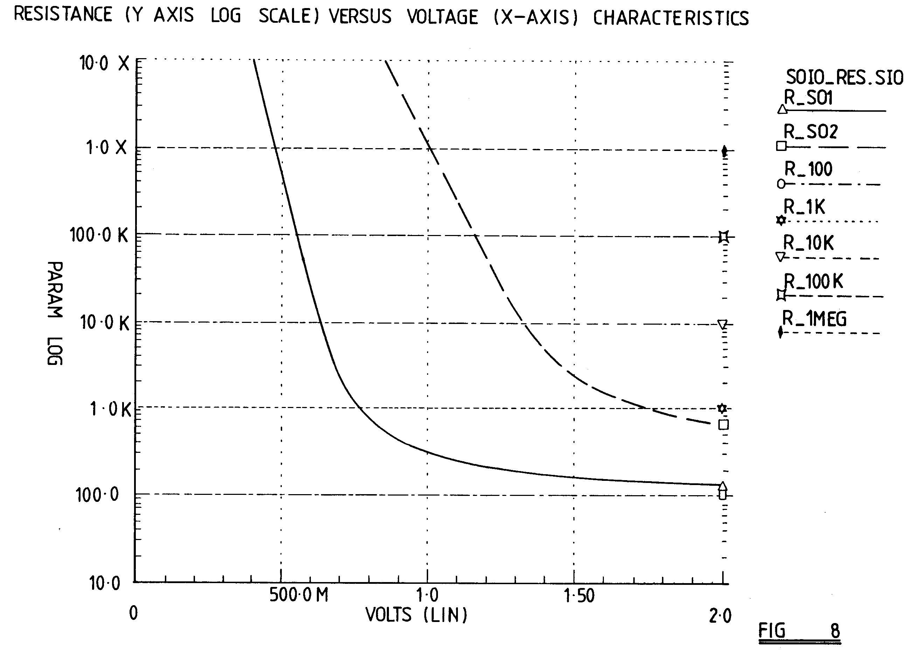

Consequently, only negligible currents will be drawn by the diode voltage divider over the full applicable voltage range so that the impedance of the terminal N of Figure 4 will remain high. This can be seen from the linear sections of the resistance versus voltage characteristics of curves I_SD1 and I_SD2 of Figure 8, corresponding to the linear sections of the curves I_SD1 and I_SD2 shown in Figure 7.

By making the voltage divider diodes of the same type and geometrical size as the transistor gate diode, all diodes will have closely matched parasitic capacitances. This results in a frequency compensated voltage divider allowing it to be used for high frequency applications. It is also possible to short drain and source of a transistor and use it as a Schottky diode as shown in Figure 5.

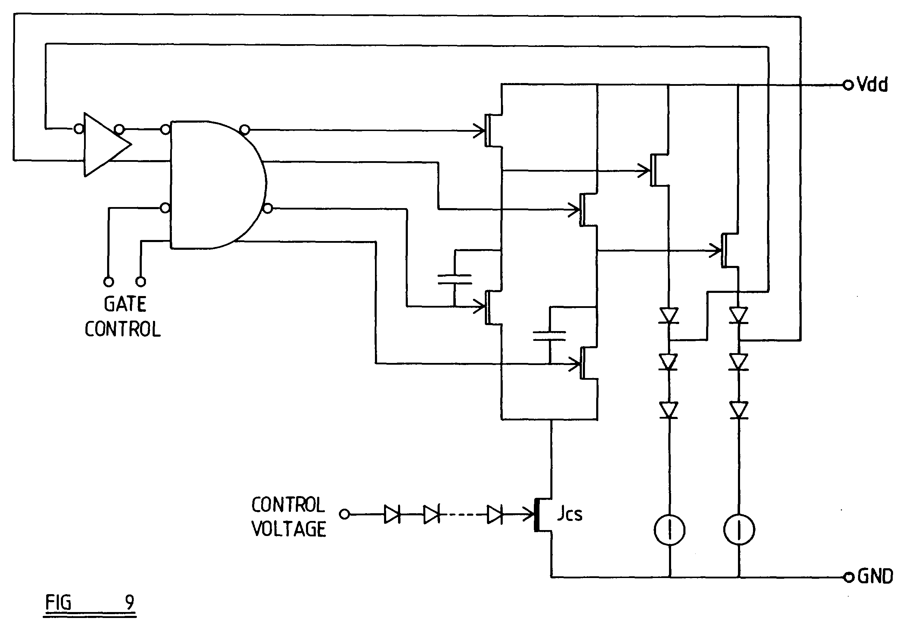

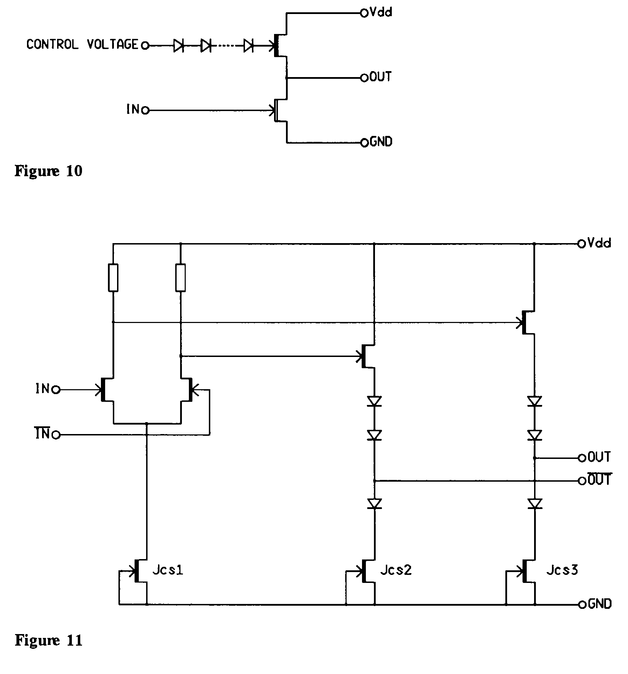

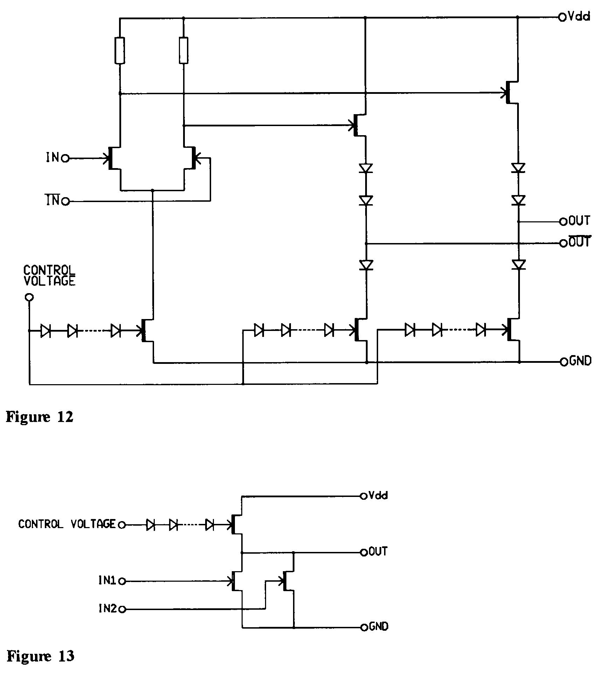

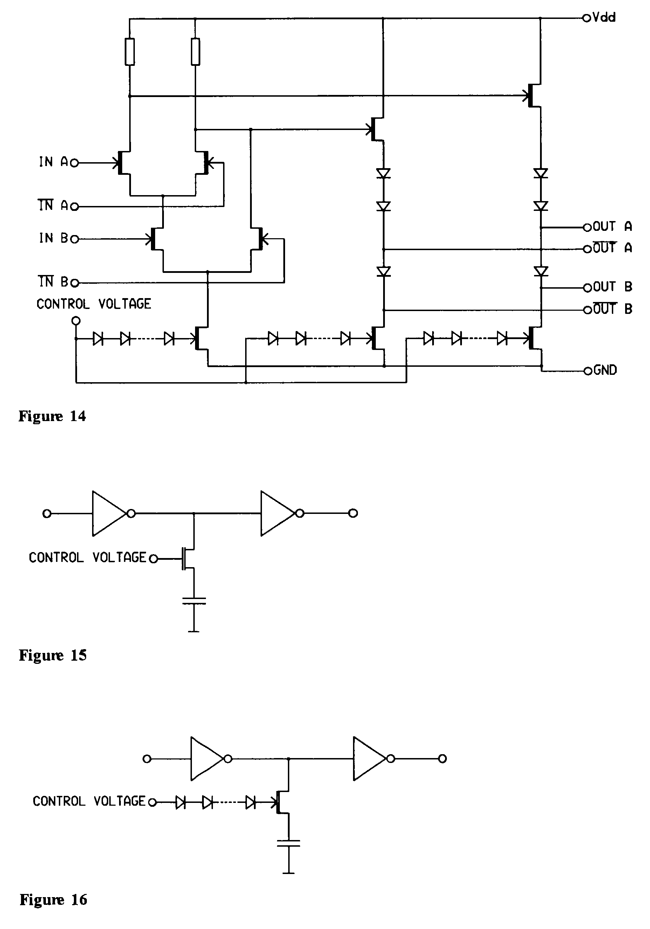

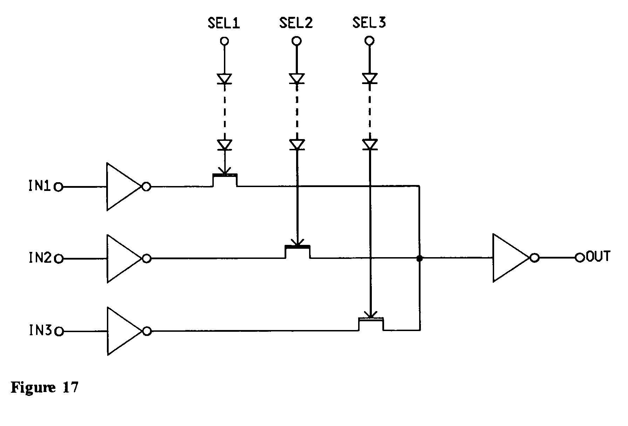

Using the above described circuit arrangement of Figure 4, a number of improvements for circuits constructed from transistors with the presence of a Schottky diode at the gate region are possible. These are as follows:
1) The inverter in the VCO of Figure 1 can be modified as shown in Figure 9 by replacing the current sink transistor Jcs and resistor R1 with a circuit arrangement according to Figure 4, resulting in a circuit with increased control voltage range, reduced sensitivity to noise and improved linearity for use in VCOs and voltage controlled delay lines (VCDLs). In contrast to the circuit of Figure 1 a control voltage range equal to the supply voltage can be provided while maintaining high impedance by connecting the appropriate number of diodes in series between the control voltage terminal and the gate of transistor Jcs.
2) An inverter which is similar and compatible in terms of logic levels to the DCFL inverter of Figure 2 can be constructed by replacing the current source transistor Jcs with a circuit arrangement according to Figure 4 as shown in Figure 10. The additional control voltage terminal allows control of the current through the inverter and thereby control of its delay/speed and power consumption. This DCFL voltage controlled delay inverter can be used as a voltage controlled delay element for low supply voltage, low power VCOs and VCDLs.
3) A SCFL inverter, as illustrated in Figure 11, can be modified by replacing the current sink transistors Jcs1...3 with a circuit arrangement according to Figure 4 as shown in Figure 12. The additional control voltage terminal enables the control of the current through the inverter and thereby its delay/speed and power consumption. This SCFL voltage controlled delay inverter can be used as a voltage controlled delay element for VCOs and VCDLs.
4) The DCFL voltage controlled inverter of Figure 10 can be extended to DCFL logic functions as shown in Figure 13. The high impedance control voltage terminal allows control of the current through the logic gate and thereby its delay/speed and power consumption.
5) The SCFL voltage controlled inverter of Figure 12 can be extended to SCFL logic functions as shown in Figure 14. The high impedance control voltage terminal allows control of the current through the logic gate and thereby its delay/speed and power consumption.
6) The circuits in Figures 10, 12, 13 and 14 can be used for complex digital circuits which can have their speed and power consumption set by means of a control voltage applied to the control voltage terminal. Since this terminal would draw virtually no current a practical implementation would be largely simplified.
7) Applying a circuit arrangement according to Figure 4 using enhancement mode FETs a voltage controlled delay inverter with a variable capacitive load as presented for CMOS in "A PLL Clock Generator with 5 to 110MHz of Lock Range for Microprocessors" by Ian A. Young, Jeffrey K. Greason, and Keng L. Wong, IEEE Journal of solid state circuits, vol.27, No.11, November 1992, as illustrated in Figure 15, can be realized using transistors with the presence of a Schottky diode at the gate region, as shown in Figure 16.
8) With a circuit arrangement according to Figure 4 pass transistor structures drawing virtually no gate current can be realized as shown in Figure 17.

Using a circuit arrangement according to Figure 4 as described above allows a complete new approach for providing circuits with a terminal for which the input voltage range can be increased to any desired value while maintaining high input impedance throughout this voltage range.

The features disclosed in the foregoing description in the following claims and/or in the accompanying drawings may, both separately and in combination thereof, be material for realising the invention in diverse forms thereof.

## Claims

1. A circuit arrangement having an input terminal (N) connected through a plurality of forward biased Schottky diodes (Jd1,Jd2..Jdn) connected in series to a gate of a transistor (Jd), wherein each Schottky diode (Jd1,Jd2..Jdn) has a Schottky barrier voltage and the number of Schottky diodes (Jd1,Jd2..Jdn) is selected such that the sum of the Schottky barrier voltages of the Schottky diodes (Jd1,Jd2..Jdn) connected in series plus the Schottky barrier voltage of the transistor gate-source diode is higher than a maximum voltage (Vₙₛ) between the terminal (N) and the source terminal of the transistor (Jd) such that the input impedance of the terminal (N) remains high.

2. A circuit arrangement according to Claim 1, wherein the diodes operate as a high impedance voltage divider such that a fraction of the terminal input voltage is effective as the gate-source voltage of the transistor, which fraction is dependent on the number of Schottky diodes connected in series.

3. A circuit arrangement according to Claim 2, wherein the operating range of the diode voltage divider is restricted to the region of its current versus voltage characteristics for which the parasitic diode series resistances have virtually no effect on the ideal exponential relationship between diode current and forward voltage.

4. A circuit arrangement according to any preceding claim, wherein all the Schottky diodes have substantially the same parasitic capacitance.

5. A circuit arrangement according to any preceding claim, wherein all the Schottky diodes are of the same type and geometrical size as the transistor gate diode formed by the gate region of the transistor.

6. A circuit arrangement according to any preceding claim, wherein at least one of the Schottky diodes comprises a transistor having its source and drain shorted.

7. A circuit arrangement according to any preceding claim, wherein the transistor is part of an integrated circuit.

8. A circuit arrangement according to any preceding claim, wherein the Schottky diodes are part of an integrated circuit.

9. A circuit arrangement according to any preceding claim, wherein the transistor is a field effect transistor.

10. A circuit arrangement according to Claim 9, wherein the transistor is a metal semi-conductor field effect transistor.

11. A circuit arrangement according to Claim 9, wherein the transistor is a high electron mobility transistor.

12. A voltage controlled oscillator incorporating a circuit arrangement according to any preceding claim.

13. A direct coupled FET logic inverter incorporating a circuit arrangement according to any one of Claims 1 to 11.

14. A coupling diode FET logic inverter incorporating a circuit arrangement according to any one of Claims 1 to 11.

15. An SCFL inverter incorporating a circuit arrangement according to any one of Claims 1 to 11.

16. A method of maintaining a high input impedance for a circuit arrangement having an input connected through a plurality of forward biased Schottky diodes connected in series to a gate of a transistor, each Schottky diode having a Schottky barrier voltage, which method comprises the step of selecting the number of Schottky diodes connected in series to the gate such that the sum of the Schottky barrier voltages of the Schottky diodes connected in series plus the Schottky barrier voltage of the transistor gate-source diode is higher than a maximum voltage between the input terminal and the source terminal of the transistor such that the impedance of the input remains high.

17. A method for extending the voltage range and maintaining high input impedance of a terminal in a circuit for controlling the current flow, delay, power dissipation and function of the circuit by connecting the terminal through a series of forward biased Schottky diodes to the gate of a transistor with the presence of a Schottky diode at the gate region to control its drain current, each Schottky diode having a Schottky barrier voltage, the high input impedance of the terminal being provided by applying Schottky diodes connected in series in such numbers that the sum of the Schottky barrier voltages of the diodes connected in series plus the Schottky barrier voltage of the transistor gate-source diode is higher than the maximum voltage applied between the terminal and the source terminal of the transistor.

18. A method according to Claim 17, wherein a delay of a logic gate is controllable via a control voltage applied to the terminal.

19. A method according to Claim 17, wherein the power consumption of a logic gate is controllable via a control voltage applied to the terminal.

20. A method according to Claim 17, wherein the function of a logic gate is controllable or modified via a control voltage applied to the terminal.

21. A method according to Claims 18 or 19, wherein the transistor current is controllable via a control voltage applied to the terminal.
